## Europäisches Patentamt
## European Patent Office
## Office européen des brevets

(11) Veröffentlichungsnummer: **0 122 491**
**B1**

(12) **EUROPÄISCHE PATENTSCHRIFT**

(45) Veröffentlichungstag der Patentschrift:
11.03.87

(51) Int. Cl.⁴: **G 01 R 25/00,** H 03 D 13/00,
H 04 N 3/16

(21) Anmeldenummer: **84103011.7**

(22) Anmeldetag: **19.03.84**

(54) **Digitaler Phasendetektor.**

(30) Priorität: **23.03.83 DE 3310581**

(43) Veröffentlichungstag der Anmeldung:
**24.10.84 Patentblatt 84/43**

(45) Bekanntmachung des Hinweises auf die Patenterteilung:
**11.03.87 Patentblatt 87/11**

(84) Benannte Vertragsstaaten:
**DE FR GB IT SE**

(56) Entgegenhaltungen:
**AT - B - 312 069**
**DE - A - 2 258 383**

**ELECTRO/80 CONFERENCE RECORD, Band 5, Mai 13-15, 1980, Boston, USA J. SILVERMAN "Applications of multiplier/detector ICs in analog communication systems", Seiten 1-8**

(73) Patentinhaber: **Siemens Aktiengesellschaft Berlin und München, Wittelsbacherplatz 2, D-8000 München 2 (DE)**

(72) Erfinder: **Hafenrichter, Reinhard, Dipl.-Ing., Wilhelm-Busch-Strasse 19, D-8905 Mering (DE)**
Erfinder: **Lüder, Rainer, Dr.-Ing., Kohlstattstrasse 10, D-8024 Oberhaching (DE)**

# Beschreibung

Die Erfindung betrifft einen digitalen Phasendetektor zur Bestimmung der Phasenabweichung $\emptyset$ zweier Impulse, von denen einer mit einer Taktfrequenz $f_T$ verkoppelt und der andere unabhängig von der Taktfrequenz $f_T$ ist.

Aus der AT-B-312 069 ist ein derartiger Phasendetektor bekannt, der jedoch eine analoge und nicht digitale Signalverarbeitung aufweist.

Ferner sind in der DE-A-22 58 383 und im Electro/80 Conference Record May 13–15, 1980 Boston, USA, Band 5 «Applications of multiplier/ detector ICs in analog communication systems» die Verwendung von A/D-Wandlern und Multiplikatoren in Phasenmessgeräten beschrieben.

Phasendetektoren werden beispielsweise bei der Ansteuerung der Horizontal-Ablenk-Endstufe in Fernsehgeräten benötigt. Hierbei wird für die Ansteuerung des Endstufentransistors ein zeilenfrequenter Basisstrom mit einer definierten Kurvenform während des Zeilenhinlaufs benötigt. Zur Einleitung des Zeilenrücklaufes muss der Basisstrom so abgeschaltet werden, dass die Kollektor-Emitter-Strecke dieses Transistors zu einer vorgegebenen Phasenlage des Zeilenoszillators, der zum BAS-Signal synchron läuft, gesperrt wird. Wegen der Ausschaltzeit des Endstufentransistors muss der Basisstrom bereits einige Zeit vor dem Sperren der Kollektor-Emitter-Strecke abgeschaltet werden. Der Basisstrom fällt dann während der Ausschaltzeit rasch auf einen negativen Spitzenwert, bis der Transistor sperrt. Die Ausschaltzeit hängt von verschiedenen Parametern wie Stromverstärkung, Temperatur, Kollektorstrom des Endstufentransistors ab, so dass der Abschaltzeitpunkt des Basisstroms ständig nachgeregelt werden muss. Dies wird durch eine Phasenregelschaltung bewerkstelligt.

Aus den genannten Gründen ist es erwünscht, den Fehler der ermittelten Phasenabweichung möglichst gering zu halten.

Bisher wurden digitale Phasendetektoren realisiert, indem z.B. ein Zähler mit einem Impuls startet und mit einem anderen Impuls wieder stoppt, oder zuerst aufwärts und anschliessend abwärts zählt. Allen diesen Lösungen ist gemeinsam, dass die Phasenabweichung einer Messung ganzzahlige Vielfache der Periodendauer der Taktfrequenz ist.

Aufgabe der Erfindung ist es, einen digitalen Phasendetektor anzugeben, der die Phasenabweichung zwischen zwei Impulsen mit einer Genauigkeit von Bruchteilen der Periodendauer der Taktfrequenz $f_T$ bestimmen kann.

Diese Aufgabe wird erfindungsgemäss dadurch gelöst, dass einem A/D-Wandler, dem der nicht mit der Taktfrequenz $f_T$ verkoppelte Impuls zugeführt wird, ein umschaltbarer Multiplizierer nachgeschaltet ist, der das Ausgangssignal des A/D-Wandlers mit den Multiplikatoren +1 oder −1 multipliziert, dass die Umschaltung des Multiplikators des Multiplizierers durch den mit der Taktfrequenz $f_T$ gekoppelten Impuls bewirkt wird, und dass dem Multiplizierer ein digitaler Integrator nachgeschaltet ist, dem das Ausgangssignal des Multiplizierers zugeführt wird und an dessen Ausgang die Phasenabweichung durch Abtastung gewonnen wird.

Bevorzugte Ausführungsformen des digitalen Phasendetektors sind in den Unteransprüchen angeführt.

Die Vorteile des erfindungsgemässen digitalen Phasendetektors werden anhand der folgenden Ausführungsbeispiele erläutert.

In der dazugehörenden Zeichnung zeigen
Fig. 1 ein Prinzipschaltbild,
die Fig. 2 bis 4 Blockschaltbilder verschiedener Ausführungsformen und
Fig. 5 ein Impulsdiagramm und den Registerinhalt eines digitalen Phasendetektors nach Fig. 4.

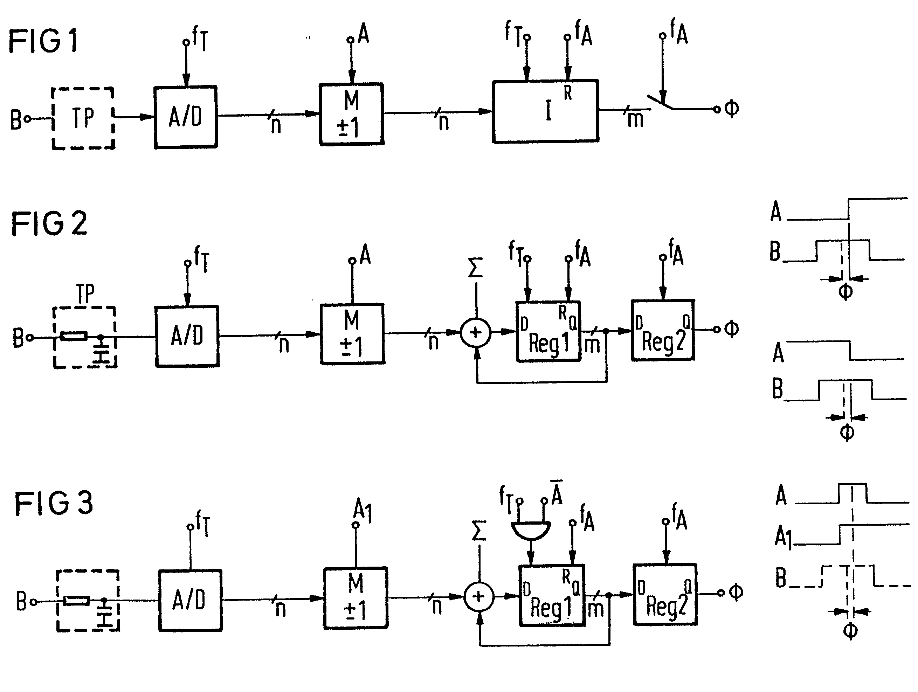

In der Fig. 1 ist der prinzipielle Aufbau des digitalen Phasendetektors gemäss der Erfindung dargestellt. Die Phase $\emptyset$ oder Zeitdifferenz, die hier gemessen wird, tritt zwischen bestimmten Pegeln oder Flanken der Impulse A und B auf. Der Impuls A ist mit der Taktfrequenz $f_T$ verkoppelt, während der Impuls B unabhängig von $f_T$ ist.

Der Impuls B wird zunächst einem analogen Tiefpass TP zugeführt und gelangt an den Eingang eines Analog/Digital-Wandlers A/D. Der analoge Tiefpass TP kann auch entfallen, wenn der Impuls B schon in geeigneter Form vorliegt.

Der A/D-Wandler tastet das Eingangssignal mit der Taktfrequenz $f_T$ ab, und die dualen Ausgangssignale des A/D-Wandlers werden einem Multiplizierer M zugeführt, der die Ausgangssignale des A/D-Wandlers mit den Multiplikatoren +1 oder −1 multipliziert. Die Umschaltung der Multiplikatoren wird mit dem Impuls A bewirkt, wobei beispielsweise die Multiplikatoren +1 mit dem L-Pegel und die Multiplikatoren −1 mit dem H-Pegel des Impulses A verknüpft sind.

Die Ausgangssignale des Multiplizierers M werden einem digitalen Integrator I zugeführt, an dessen Ausgang die Phase $\emptyset$ durch Abtastung mit der Frequenz $f_A$ gewonnen wird.

Durch die Kombination Tiefpass TP und A/D-Wandler wird die höhere Genauigkeit der Phasenmessung erreicht. Der Tiefpass TP wandelt die Information über den Zeitpunkt einer Pegeländerung des Impulses B in eine Amplitudeninformation um. Aus der Abtastung der Amplitude mit der Taktfrequenz $f_T$ erhält man dann wieder Informationen über den Zeitpunkt der Pegeländerung.

In der Fig. 2 ist ein Blockschaltbild eines digitalen Phasendetektors dargestellt, bei dem die Phasenabweichung $\emptyset$ zwischen dem Pegel des Impulses B und der negativen oder positiven Flanke des Impulses A bestimmt wird.

Der digitale Integrator besteht dabei aus einem Register Reg 1 und einem Addierer $\Sigma$.

Der A/D-Wandler liefert nun bei L-Pegel für den Impuls B das Datenwort O, und für Pegel > L positive Werte. Da der Multiplizierer M mit der Flanke des Impulses A umschaltet, liegen beispielsweise am Ausgang des Multiplizierers M für die Zeit, während der Impuls B auf H und Impuls A auf dem Pegel vor der Flanke liegt, positive und während der restlichen Zeit des Impulses B negative Datenwerte. Diese Datenwerte werden nun fortlaufend mit der Taktfrequenz $f_T$ durch den Addierer $\Sigma$ im Register Reg 1 aufsummiert, so dass nach Ende des Impulses B am Ausgang des Registers Reg 1 die Phase $\emptyset$ liegt und in das nächste Register Reg 2 übernommen werden kann.

Wie den beiden Impulsdiagrammen der Fig. 2 entnommen werden kann, wird somit die Phasenabweichung zwischen dem Pegel (Impulsmitte) des Impulses B und der negativen oder positiven Flanke des Impulses A bestimmt.

In der Fig. 3 ist das Blockschaltbild eines weiteren Ausführungsbeispieles eines Phasendetektors dargestellt, der die Phasenabweichung $\emptyset$ zwischen den Pegeln (Impulsmitten) der Impulse A und B bestimmt. Der Aufbau entspricht dem Phasendetektor gemäss Fig. 2 mit der Änderung, dass das Register Reg 1 gesperrt ist, wenn der Impuls A auf H liegt, so dass während dieser Zeitdauer der Inhalt des Registers Reg 1 unverändert bleibt. Der Multiplizierer M wird mit dem Impuls $A_1$ geschaltet, der gleichzeitig mit dem Impuls A von Lauf H-Pegel wechselt, jedoch mindestens so lange auf H-Pegel bleibt, bis der Impuls B von H- auf L-Pegel gewechselt hat.

Während der ersten Zeitdauer (A = 0, $A_1$ = 0, B = 1) liegt somit am Multiplizierer M ein positives und während der zweiten Zeitdauer (A = 0, $A_1$ = 1, B = 1) ein negatives Ausgangssignal. Wie dem Impulsdiagramm der Impulse A und B zu entnehmen ist, repräsentiert der Ausgang des Registers Reg 2 die Phase $\emptyset$ zwischen den Pegeln (Impulsmitten) der Impulse A und B.

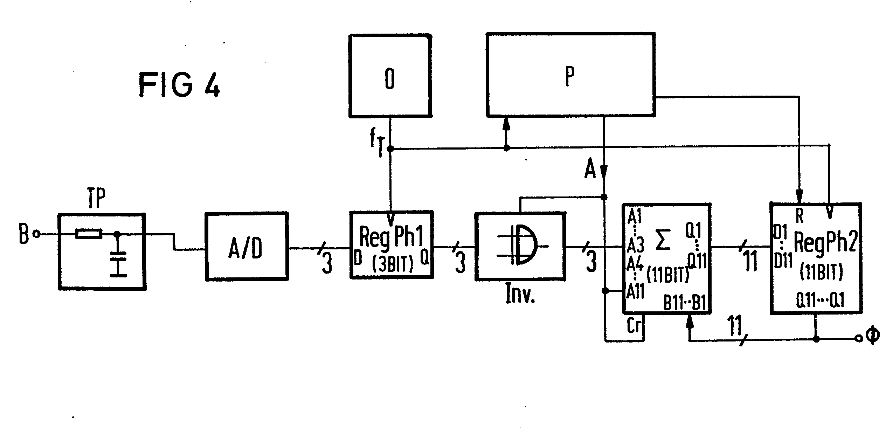

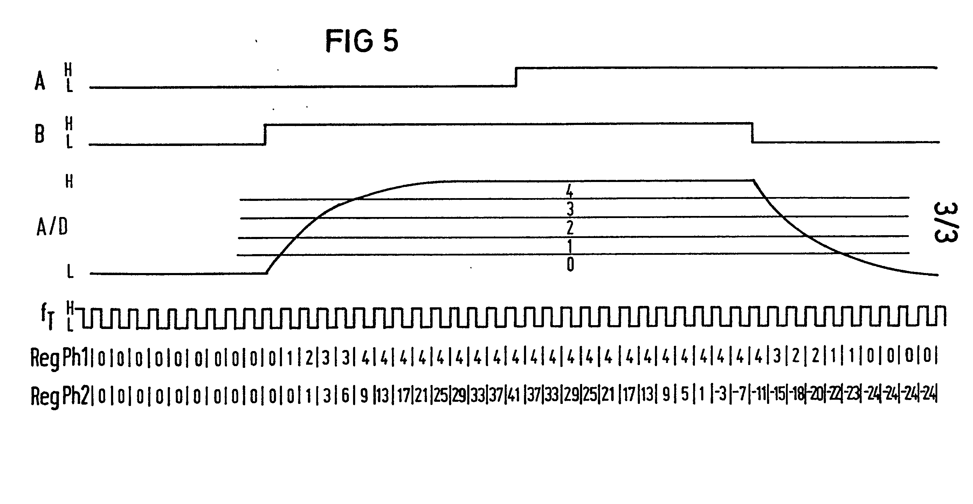

Anhand des in der Fig. 4 dargestellten Blockschaltbildes eines digitalen Phasendetektors und des in der Fig. 5 dargestellten dazugehörenden Impulsdiagramms wird die Arbeitsweise des erfindungsgemässen Phasendetektors näher erläutert. Die Ausführungsform entspricht dabei dem in der Fig. 2 dargestellten Phasendetektor, bei dem also die Phasenlage $\emptyset$ zwischen dem Pegel (Impulsmitte) des Impulses B und der negativen oder positiven Flanke des Impulses A bestimmt wird.

Der Impuls B wird zunächst dem Tiefpass TP zugeführt, der die rechteckförmigen Flanken des Impulses B in e-Funktionen umwandelt. Diese Spannung, die in der Fig. 5 mit A/D bezeichnet ist, wird als Eingangsspannung dem Analog/Digital-Wandler A/D zugeführt, der vier Entscheidungsschwellen aufweist, die sich zwischen den Pegeln L und H des Impulses B befinden und gleichmässig in diesem Bereich verteilt sind (siehe Fig. 5).

Die Zeitkonstante des Tiefpasses TP muss so bemessen sein, dass sich während mehrerer Perioden der Taktfrequenz $f_T$ die Spannung am A/D-Wandler in dem Bereich oberhalb der untersten und unterhalb der obersten Entscheidungsschwelle befindet. Ferner muss während der Dauer des Impulses B die oberste Entscheidungsschwelle sicher überschritten und nach Ende des Impulses B die unterste Entscheidungsschwelle unterschritten werden, bevor der nächste Impuls ansteht.

Das Ergebnis der A/D-Wandlung gelangt zu dem Register Reg. Ph 1 und wird dort mit der Taktfrequenz $f_t$, die von dem Oszillator O erzeugt wird, übernommen. Die Ausgänge des Registers Reg. Ph 1 werden in einem umschaltbaren Addierer/Subtrahierer-Netzwerk mit den Daten des Registers Reg. Ph 2 verknüpft und das Ergebnis wieder in Register 2 gespeichert. Das umschaltbare Addierer/Subtrahierer-Netzwerk wird durch den steuerbaren Inverter Inv. und den Addierer $\Sigma$, beispielsweise in 11 bit-Ausführung, gebildet. Die Umschaltung des Inverters Inv., der hier anstelle des Multiplizierers steht, geschieht mit dem von der Impulserzeugung P gelieferten Impuls A. Es wird somit der Inhalt der Register Reg. Ph 1 und Reg. Ph 2 addiert, solange der Impuls A auf L liegt. Befindet sich der Impuls A auf H, so wird der invertierte Inhalt von Register Reg. Ph 1 zum Inhalt des Registers Reg. Ph 2 addiert, was identisch mit einer Subtraktion ist.

Nach Ende des Impulses B bzw. der daraus resultierenden e-Funktion enthält das Register Reg. Ph 2 die Phase $\emptyset$ zwischen den Impulsen A und B als digitales Wort. Die Phase $\emptyset$ beträgt 0, wenn die zeitliche Impulsmitte des Impulses B etwas links von der positiven Flanke des Impulses A liegt, wobei der genaue Zeitpunkt von der Zeitkonstante des Tiefpasses abhängt. Trifft der Impuls B früher (später) als zu dem angeführten Zeitpunkt ein, so ergeben sich mehr oder weniger grosse negative (positive) Phasen $\emptyset$.

In der Fig. 5 sind unterhalb des Impulsdiagramms die Inhalte der Register Reg. Ph 1 und Reg. Ph 2 für eine willkürlich gewählte Phasenlage und einen A/D-Wandler mit vier Entscheidungsschwellen dargestellt.

Die nominelle Auflösung $\triangle$ T des erfindungsgemässen digitalen Phasendetektors beträgt

$$\triangle \text{T} = (2 \, \text{n} \, f_T)^{-1},$$

wobei n der Anzahl der Entscheidungsschwellen entspricht. Daraus ist ersichtlich, dass die Phase $\emptyset$ zwischen den zwei Impulsen A und B mit einer Genauigkeit von Bruchteilen der Periodendauer der Taktfrequenz $f_T$ erfasst werden kann.

Bei der eingangs erwähnten Ansteuerung des Endstufentransistors der Horizontal-Ablenkschaltung in Fernsehgeräten ist es notwendig, die Phasenabweichung zwischen der Mitte des Zeilenrücklaufimpulses und einem von PLL-Teiler abgeleiteten Phasenvergleichsimpulses zu messen. Dazu wird der Zeilenrücklaufimpuls einem Komparator zugeführt, der einen Rechteckimpuls von der Breite des Zeilenrücklaufes erzeugt. Dieser Rechteckimpuls entspricht dem Impuls B der Ausführungsbeispiele. Der nachfolgende Tiefpass TP verschleift die Flanken dieses Rechteckimpulses mit einer Zeitkonstanten von etwa 0,5 ... 3 µs. Die vom Zeilenoszillator abgeleitete Taktfrequenz $f_T$ beträgt dabei 16 MHz so dass die Datenwerte vom A/D-Wandler alle 62,5 ns im Ausgangsregister Reg. Ph 1 bereitgestellt werden.

Der Phasenvergleichsimpuls, der dem Impuls A der oben angeführten Ausführungsbeispiele entspricht, wird vom Zeilenoszillator abgeleitet und weist eine Frequenz $f_A$ von 15,625 kHz auf.

Aus der zeitlichen Beziehung der steigenden Flanke des Phasenvergleichsimpulses zu den Daten vom A/D-Wandler wird in jeder Zeile ein Phasenfehler errechnet und am Ausgang im Dualcode bereitgestellt. In die Phasenabweichung geht auch die Zeitkonstante des Tiefpasses TP mit ein, so dass durch eine Veränderung dieser Zeitkonstante die horizontale Phasenlage des Fernsehbildes eingestellt werden kann.

Aus der weiter oben angeführten Formel ergibt sich, dass die nominelle Auflösung $\triangle$ T des Phasendetektors bei einer Taktfrequenz $f_T$ von 16 MHz, also einer Taktzeit von 62,5 ns, und einem A/D-Wandler mit vier Entscheidungsschwellen

$$\triangle T = 62,5/8\ ns$$

beträgt. Die Genauigkeit mit der die Phasenabweichung zwischen der Mitte des Zeilenrücklaufimpulses und dem Phasenvergleichsimpuls gemessen wird, beträgt damit ca. 8 ns, was wesentlich niedriger als die Periodendauer der Taktfrequenz $f_T$ ist.

## Patentansprüche

1. Digitaler Phasendetektor zur Bestimmung der Phasenabweichung zweier Impulse (A, B) von denen einer mit einer Taktfrequenz $f_T$ verkoppelt (A) und der andere (B) unabhängig von der Taktfrequenz $f_T$ ist, dadurch gekennzeichnet, dass einem A/D-Wandler, dem der nicht mit der Taktfrequenz $f_T$ verkoppelte Impuls (B) zugeführt wird, ein umschaltbarer Multiplizierer (M) nachgeschaltet ist, der das Ausgangssignal des A/D-Wandlers mit den Multiplikatoren +1 oder −1 multipliziert, dass die Umschaltung des Multiplikators des Multiplizierers (M) durch den mit der Taktfrequenz $f_T$ gekoppelten Impuls (A) bewirkt wird, und dass dem Multiplizierer (M) ein digitaler Integrator (I) nachgeschaltet ist, dem das Ausgangssignal des Multiplizierers (M) zugeführt wird und an dessen Ausgang die Phasenabweichung ($\varnothing$) durch Abtastung gewonnen wird.

2. Digitaler Phasendetektor nach Anspruch 1, dadurch gekennzeichnet, dass der digitale Integrator aus einem Register (Reg. 1) und einem Addierer ($\Sigma$) besteht.

3. Digitaler Phasendetektor nach Anspruch 1 oder 2, dadurch gekennzeichnet, dass der Multiplizierer (M) durch einen steuerbaren Inverter (Inv.) gebildet ist.

4. Digitaler Phasendetektor nach einem der Ansprüche 1 bis 3, dadurch gekennzeichnet, dass der A/D-Wandler mehrere Entscheidungsschwellen aufweist, die sich zwischen den Pegeln L und H des Impulses B befinden.

5. Digitaler Phasendetektor nach einem der Ansprüche 1 bis 4, dadurch gekennzeichnet, dass dem A/D-Wandler ein Tiefpass (TP) vorgeschaltet ist.

6. Digitaler Phasendetektor nach einem der Ansprüche 1 bis 5, dadurch gekennzeichnet, dass zwischen den A/D-Wandler und den Multiplizierer (M) ein Register (Reg. Ph 1) geschaltet ist, das die Ausgangssignale des A/D-Wandlers enthält.

7. Digitaler Phasendetektor nach einem der Ansprüche 1 bis 6, dadurch gekennzeichnet, dass dem Ausgang des digitalen Integrators ein Register (Reg. 2) nachgeschaltet ist, das die Werte der Phasenabweichung ($\varnothing$) enthält.

## Revendications

1. Détecteur numérique de phase pour déterminer la différence de phase de deux impulsions (A, B), dont l'une (A) est accouplée à une fréquence d'horloge $f_T$ et dont l'autre (B) est indépendante de la fréquence d'horloge $f_T$, caractérisé par le fait qu'en aval d'un convertisseur analogique/numérique, auquel est envoyée l'impulsion (B) non accouplée à la fréquence d'horloge $f_T$, se trouve branché un multiplicateur commutable (M), qui multiplie le signal de sortie du convertisseur analogique/numérique avec les multiplicateurs +1 ou −1, que la commutation du facteur de multiplication du multiplicateur (M) est réalisée au moyen de l'impulsion (A) accouplée à la fréquence d'horloge $f_T$, et qu'en aval du multiplicateur (M) se trouve branché un intégrateur numérique (I), auquel le signal de sortie du multiplicateur (M) est envoyé et à la sortie duquel la différence de phase ($\varnothing$) est obtenue par exploration.

2. Détecteur numérique de phase suivant la revendication 1, caractérisé par le fait que l'intégrateur numérique est constitué par un registre (Reg. 1) et par un additionneur ($\Sigma$).

3. Détecteur numérique de phase suivant la revendication 1 ou 2, caractérisé par le fait que le multiplicateur (M) est formé par un inverseur commandable (Inv.).

4. Détecteur numérique de phase suivant l'une des revendications 1 à 3, caractérisé par le fait que le convertisseur analogique/numérique comporte plusieurs seuils de décision, qui sont situés entre les niveaux L et H de l'impulsion B.

5. Détecteur numérique de phase suivant l'une des revendications 1 à 4, caractérisé par le fait que le filtre passe-bas (TP) est branché en amont du convertisseur analogique/numérique.

6. Détecteur numérique de phase suivant l'une des revendications 1 à 5, caractérisé par le fait qu'entre le convertisseur analogique/numérique et le multiplicateur (M) se trouve branché un registre (Reg. Ph 1), qui contient les signaux de sortie du convertisseur analogique/numérique.

7. Détecteur numérique de phase suivant l'une des revendications 1 à 6, caractérisé par le fait qu'en aval de l'intégrateur numérique se trouve branché un registre (Reg. 2), qui contient les valeurs de la différence de phase ($\varnothing$).

## Claims

1. A digital phase detector which serves to determine the phase deviation between two pulses (A, B), one (A) of which is coupled to a clock frequency $f_T$ and the other (B) of which is independent of the clock frequency $f_T$, characterised in that an A/D-converter, which is supplied with that pulse (B) which is not coupled to the clock frequency $f_T$ is connected at its output to a multiplier (M) which has switch-over facilities and which multiplies the output signal from the A/D-converter by the multiplier factors +1 or −1, that the switch-over of the multiplier factor of the multiplier (M) is implemented by the pulse (A) which is coupled to the clock frequency $f_T$, and that the multiplier (M) is connected at its output to a digital integrator (I) which is supplied with the output signal from the multiplier (M) and from the output of which the phase deviation ($\varnothing$) is obtained by sampling.

2. A digital phase detector as claimed in claim 1, characterised in that the digital integrator comprises a register (Reg 1) and an adder ($\Sigma$).

3. A digital phase detector as claimed in claim 1 or 2, characterised in that the multiplier (M) comprises a controllable inverter (Inv.).

4. A digital phase detector as claimed in one of the claims 1 to 3, characterised in that the A/D-converter has a plurality of decision thresholds which occur between the levels L and H of the pulse B.

5. A digital phase detector as claimed in one of the claims 1 to 4, characterised in that the A/D-converter is preceded by a low-pass filter (TP).

6. A digital phase detector as claimed in one of the claims 1 to 5, characterised in that a register (Reg. Ph 1) which contains the output signals from the A/D-converter is connected between the A/D-converter and the multiplier.

7. A digital phase detector as claimed in one of the claims 1 to 6, characterised in that the output of the digital integrator is connected to a register (Reg. 2) which contains the values of the phase deviation ($\varnothing$).

FIG1

FIG2

FIG3

FIG 4

0 122 491

FIG 5